# DEMANDE DE BREVET EUROPEEN

(11) **EP 0 962 966 A1**
(43) Date de publication de la demande: **08.12.1999**
(21) Numéro de dépôt: 99401337.3
(22) Date de dépôt: 03.06.1999
(51) Int. Cl.: H01L 21/331, H01L 29/737, H01L 29/08

(54) **Transistor bipolaire vertical à faible bruit et procédé de fabrication correspondant**

(30) Priorité: 05.06.1998 FR 9807059
(71) Demandeur: STMicroelectronics S.A., 94250 Gentilly (FR); COMMISSARIAT A L'ENERGIE ATOMIQUE, 75015 Paris (FR); FRANCE TELECOM, 75015 Paris (FR)
(72) Inventeur: Chantre, Alain, 38180 Seyssins (FR); Marty, Michel, 38760 St. Paul de Varces (FR); Dutartre, Didier, 38240 Meylan (FR); Monroy, Augustin, 38400 St. Martin d'Hères (FR); Laurens, Michel, 38120 St. Egrève (FR); Guette, Francois, 38330 Montbonnot St. Martin (FR)
(74) Mandataire: Casalonga, Axel

(57) **Abrégé**

Le collecteur intrinsèque (4) est épitaxié sur une couche de collecteur extrinsèque (2) enterrée dans un substrat semiconducteur (1). Une région d'isolement latéral (5) entoure la partie supérieure du collecteur intrinsèque et on réalise un puits de collecteur extrinsèque déporté (60). On réalise une base à hétérojonction SiGe (8) située au-dessus du collecteur intrinsèque et de la région d'isolement latéral à partir d'une épitaxie non sélective, et on réalise un émetteur dopé in situ (11) par une épitaxie sur une fenêtre prédéterminée (80) de la surface de la base située au dessus du collecteur intrinsèque de façon à obtenir au moins au-dessus de ladite fenêtre une région d'émetteur formée de silicium monocristallin et directement en contact avec le silicium de la base.

## Description

L'invention concerne les transistors bipolaires verticaux, notamment ceux destinés à s'intégrer dans les technologies haute fréquence et à très haut degré d'intégration (technologie VLSI : "Very Large Scale Integration" en langue anglaise), et en particulier les caractéristiques et la réalisation des émetteurs de ces transistors.

Dans les technologies bipolaires à émetteur polysilicium, l'émetteur résulte d'un dépôt de polysilicium qui peut être effectué dans un four classique suivi d'un dopage. En variante, l'émetteur peut être dopé in situ dans un réacteur de dépôt chimique en phase vapeur (dépôt CVD: "Chemical Vapor Deposition").

Dans les deux cas, une couche d'oxyde est présente à l'interface émetteur/base. Cette couche limite le courant de trous dans la base (les électrons injectés continuent à passer par effet tunnel) ce qui contribue à obtenir un gain en courant (Ic/Ib) suffisant.

Cependant, ces transistors à émetteur polysilicium possèdent certains inconvénients. Ils présentent tout d'abord du bruit à basse fréquence ce qui se traduit par des fluctuations basse fréquence du courant du transistor. Ceci est d'autant plus gênant pour des circuits radiofréquence incorporant de tels transistors et à l'aide desquels on souhaite séparer deux porteuses proches, ou encore pour des oscillateurs.

Par ailleurs, les caractéristiques dimensionnelles de la couche d'oxyde à l'interface base-émetteur polysilicium influent sur les paramètres statiques du transistor, notamment son gain. Or, il est particulièrement délicat de garantir des caractéristiques identiques pour des interfaces d'oxyde de tous les transistors de plusieurs lots, et ce notamment lorsque la surface des émetteurs varie. En conséquence, il est particulièrement délicat d'obtenir des caractéristiques homogènes de tous les transistors réalisés quelle que soit la surface de leur émetteur.

L'invention vise à apporter une solution à ces problèmes.

Un but de l'invention est de réduire le bruit basse fréquence tout en conservant des paramètres statiques acceptables, et notamment un gain correct en courant.

Un autre but de l'invention est de permettre l'obtention d'une meilleure homogénéité des caractéristiques des transistors quelle que soit la surface de leur émetteur.

L'invention a encore pour but de proposer un transistor bipolaire dont le dopage de l'émetteur permette à la fois une bonne efficacité d'injection des électrons et une bonne siliciuration de la surface supérieure de l'émetteur.

L'invention propose donc un procédé de fabrication d'un transistor bipolaire vertical comprenant une étape de réalisation d'un collecteur intrinsèque, par exemple par épitaxie ou implantation, sur une couche de collecteur extrinsèque enterrée dans un substrat semiconducteur, une étape de réalisation d'une région d'isolement latéral entourant la partie supérieure du collecteur intrinsèque, et d'un puits de collecteur extrinsèque déporté, une étape de réalisation d'une basé à hétéro-jonction SiGe (Silicium-Germanium) située au-dessus du collecteur intrinsèque et de la région d'isolement latéral et comportant une épitaxie non sélective d'un empilement de couches comportant au moins une couche de SiGe, par exemple une couche de SiGe encapsulée par deux couches de silicium ou bien une couche de SiGe surmontant une couche de silicium, et une étape de réalisation d'un émetteur dopé in situ comportant une épitaxie sur une fenêtre prédéterminée de la surface dudit empilement ("fenêtre émetteur"), fenêtre située au-dessus du collecteur intrinsèque, de façon à obtenir au moins au-dessus de ladite fenêtre, une région d'émetteur formée de silicium monocristallin et directement en contact avec la couche supérieure de l'empilement, par exemple le silicium de la couche supérieure d'encapsulation dudit empilement.

En d'autres termes, l'invention propose la réalisation d'un émetteur épitaxié monocristallin directement sur la "base", (par abus de langage car en fait la jonction émetteur/base délimitant la partie supérieure de la base intrinsèque se situe dans la couche supérieure d'encapsulation) de sorte que l'on s'affranchisse de la présence d'une couche d'oxyde d'interface. L'émetteur monocristallin épitaxié, qui se traduit par une absence d'oxyde d'interface, conduit par conséquent à une meilleure homogénéité des caractéristiques des transistors, quelle que soit la surface des émetteurs.

Par ailleurs, il a été observé que de tels transistors à émetteur épitaxié directement sur la base, et par conséquent s'affranchissant d'oxyde d'interface, présentaient une réduction notable du bruit basse fréquence. En outre, la présence d'une base à hétérojonction silicium-germanium permet, en combinaison avec un émetteur épitaxié directement sur la base, de compenser dans une mesure acceptable, la perte du gain occasionnée par la disparition de la couche d'oxyde d'interface.

Enfin, le fait d'utiliser un dopage in situ de l'émetteur, en combinaison avec un émetteur monocristallin, permet lors de la réalisation de l'émetteur, de moduler la quantité de dopant au fur et à mesure de la croissance de l'émetteur ce qui permet, comme on le verra plus en détail ci-après, dans un mode de mise en oeuvre particulièrement avantageux, d'obtenir une concentration de dopant plus importante dans le bas de l'émetteur que dans le haut de l'émetteur. Cet avantage n'est pas possible avec un émetteur polycristallin car le dopant se répartit naturellement à l'intérieur du polysilicium en raison de la présence des joints de grains.

Selon un mode de mise en oeuvre de l'invention, l'étape de réalisation de l'émetteur comprend :
- une première phase comportant le dépôt sur la surface dudit empilement d'une première couche de dioxyde de silicium, le dépôt sur la première couche de dioxyde de silicium d'une deuxième couche de nitrure de silicium, une gravure dans la couche de nitrure de silicium avec arrêt sur la première couche de dioxyde de silicium d'une zone correspondant à l'emplacement de la fenêtre émetteur, puis une désoxydation chimique de ladite zone de façon à obtenir dans ladite fenêtre une surface de silicium ayant une concentration d'atomes d'oxygène inférieure à 10¹⁵/cm², et
- une deuxième phase comportant l'exposition du bloc semi-conducteur obtenu à ladite première phase, à un mélange gazeux de silane et de dopants en atmosphère contrôlée non oxydante, par exemple sous vide, dans un réacteur de dépôt CVD ultrapropre bien connu de l'homme du métier.

Ainsi, l'invention permet d'utiliser des conditions classiques de dépôt de polysilicium dans un réacteur CVD ultrapropre. Cependant, le silicium croît monocristallin sur la base en raison du caractère chimiquement propre de la fenêtre de celle-ci.

Selon une première variante de l'invention, à l'issue de la deuxième phase on obtient une couche de silicium, monocristalline au moins au-dessus de ladite fenêtre, que l'on grave de façon à former un émetteur comportant une région supérieure plus large que la fenêtre et s'appuyant sur une partie de la couche de nitrure de silicium. On forme alors des espaceurs isolants au contact des parois verticales de la région supérieure plus large de l'émetteur.

Selon une autre variante de l'invention, ladite première phase comporte le dépôt sur la deuxième couche de nitrure de silicium, d'une troisième couche épaisse de dioxyde de silicium, et une gravure préliminaire dans la troisième couche de dioxyde de silicium avec arrêt sur la deuxième couche de nitrure de silicium, d'une région correspondant à l'emplacement de ladite zone, et par conséquent de la fenêtre émetteur, de façon à obtenir à l'issue de la première phase, un bloc semiconducteur comportant en empilement des trois couches isolantes délimitant une cavité de même largeur que ladite fenêtre. A l'issue de la deuxième phase, c'est-à-dire après épitaxie de l'émetteur, on obtient un remplissage de ladite cavité par ladite épitaxie, on grave la troisième couche de dioxyde de silicium de part et d'autre du bloc émetteur formé dans la cavité et on forme des espaceurs isolants au contact des parois verticales de l'émetteur.

En d'autres termes, selon cette variante de l'invention, on obtient une distance plus réduite entre le bord de l'émetteur et la zone implantée de base extrinsèque ce qui contribue à diminuer encore la résistance de base ainsi que la capacité base-collecteur. En outre, cette distance réduite est contrôlée par un seul niveau de photolithographie.

Selon un mode de mise en oeuvre de l'invention, qui peut du reste s'appliquer à l'une ou l'autre des variantes qui viennent d'être exposées, on module dans la deuxième phase, la quantité de gaz dopant de façon à obtenir une concentration de dopant plus faible dans la partie supérieure de l'émetteur que dans la partie inférieure directement en contact avec la base. Ceci permet d'obtenir à la fois une bonne efficacité d'injection des électrons et une bonne siliciuration de la partie supérieure de l'émetteur.

L'invention a également pour objet un transistor bipolaire vertical comprenant un collecteur intrinsèque disposé sur une couche de collecteur extrinsèque enterrée dans un substrat semiconducteur, une région d'isolement latéral entourant la partie supérieure du collecteur intrinsèque, un puits de collecteur extrinsèque déporté, une base à hétérojonction SiGe située au-dessus du collecteur intrinsèque et de la région d'isolement latéral et formée dans un empilement de couches comportant au moins une couche de SiGe, par exemple une couche de SiGe encapsulée par deux couches de silicium. et un émetteur dopé, entouré par la base extrinsèque, comportant au moins au-dessus d'une fenêtre prédéterminée de la surface dudit empilement située au-dessus du collecteur intrinsèque, une région d'émetteur formée de silicium monocristallin et directement en contact avec la couche supérieure de l'empilement, par exemple le silicium de la couche supérieure d'encapsulation dudit empilement.

Ladite fenêtre de la surface dudit empilement comporte une concentration d'atomes d'oxygène avantageusement inférieure à 10¹⁵/cm².

Selon un premier mode de réalisation de l'invention, l'émetteur comporte une région supérieure plus large que la fenêtre et s'appuyant sur une couche de nitrure de silicium elle-même supportée par une couche de dioxyde de silicium reposant sur une partie de la base. L'émetteur comporte par ailleurs des espaceurs isolants en contact des parois verticales de la région supérieure plus large de l'emetteur et s'appuyant sur la couche de dioxyde de silicium.

Selon un autre mode de réalisation de l'invention, l'émetteur est formé d'un bloc de même largeur que la fenêtre s'appuyant intégralement directement sur ledit empilement. Il comporte des espaceurs isolants au contact des parois verticales de l'émetteur et s'appuyant sur une couche de dioxyde de silicium.

Selon un autre mode de réalisation de l'invention, l'émetteur est dopé plus faiblement dans sa partie supérieure que dans sa partie inférieure directement en contact avec la base.

D'autres avantages et caractéristiques de l'invention apparaîtront à l'examen de la description détaillée de modes de mise en oeuvre et de réalisation, nullement limitatifs, et des dessins annexés sur lesquels :
- les figures 1 à 6 illustrent schématiquement un premier mode de mise en oeuvre du procédé selon l'invention aboutissant à un premier mode de réalisation d'un transistor bipolaire selon l'invention, et
- les figures 7 à 11 illustrent schématiquement un deuxième mode de mise en oeuvre du procédé selon l'invention aboutissant à un deuxième mode de réalisation d'un transistor bipolaire selon l'invention.

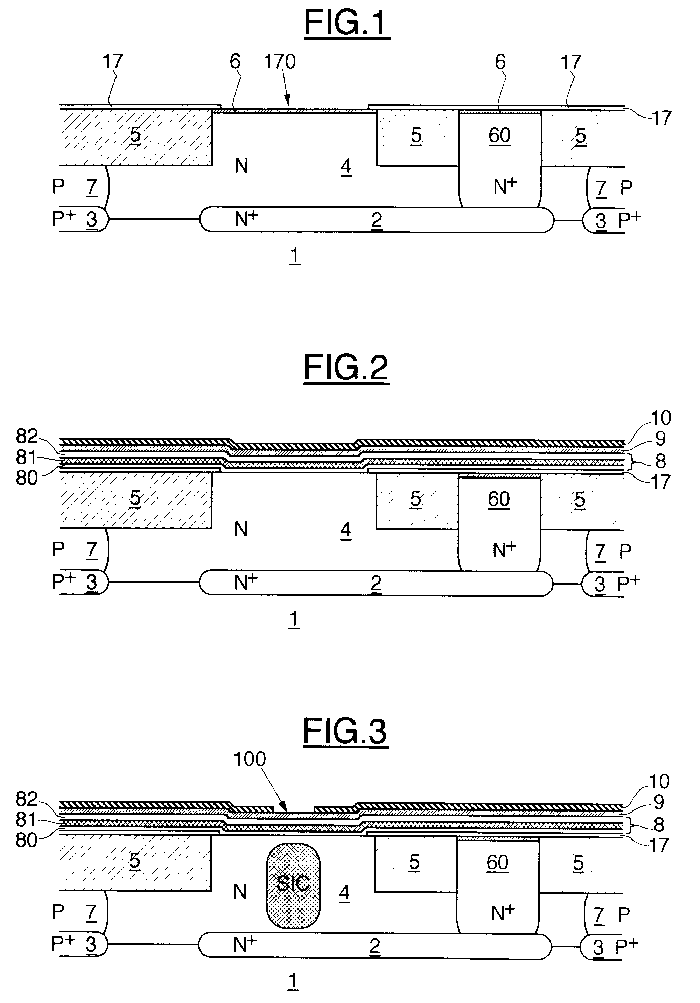

Sur la figure 1, la référence 1 désigne un substrat de silicium, par exemple du type P à la surface duquel on réalise de façon classique et connue en soi une couche enterrée 2 de collecteur extrinsèque, dopée N⁺, par une implantation d'arsenic.

On réalise de même, de façon classique, de part et d'autre du collecteur extrinsèque 2, deux couches enterrées 3, dopées P⁺ à partir d'une implantation de bore.

Sur le substrat 1 ainsi formé, on réalise une épitaxie épaisse, connue en soi, de façon à réaliser une couche 4 de silicium monocristalline de type N ayant une épaisseur typiquement de l'ordre de 1 micron.

On réalise ensuite dans cette couche 4, de façon connue en soi, une région d'isolement latéral 5, soit par un procédé d'oxydation localisée (ou LOCOS), soit du type "tranchée peu profonde" ("Shallow Trench"). On a représenté sur la figure 1, à des fins de simplification, une région d'isolement latéral 5 du type à tranchée peu profonde.

On réalise également de façon classique, notamment par implantation de phosphore, un puits collecteur 60 dopé N⁺ contactant la couche enterrée 2.

On réalise ensuite des implantations de bore de façon à réaliser sous la région d'isolement latéral 5 des caissons 7 dopés P permettant un isolement vis-à-vis des transistors adjacents au transistor bipolaire décrit ici.

On fait croître ensuite, de façon classique, sur la surface du collecteur intrinsèque monocristallin épitaxié 4, un oxyde thermique, typiquement du dioxyde de silicium. Cette croissance de dioxyde de silicium se produit également sur toute la plaquette, et notamment sur le puits collecteur 60. Cet oxyde forme également l'oxyde de grille pour des transistors complémentaires à effet de champ à grilles isolées (transistors CMOS) réalisés conjointement au transistor bipolaire sur la même plaquette (technologie BiCMOS: Bipolaire-CMOS).

On dépose ensuite sur le bloc semiconducteur ainsi formé une couche 17 de silicium amorphe ayant une épaisseur de l'ordre de 500 Å.

On grave ensuite, par gravure plasma avec arrêt sur la couche d'oxyde 6, une fenêtre 170 dite "fenêtre de base". Dans le cas où un isolement latéral du type tranchée peu profonde est utilisé, les deux parties de la couche 17 de silicium gravée débordent légèrement au-dessus du collecteur intrinsèque 4. Dans le cas où un isolement latéral du type LOCOS est utilisé, la fenêtre 170 de gravure peut être plus large que le collecteur intrinsèque 4.

On procède ensuite (figure 2) à une désoxydation chimique de la couche d'oxyde 6 située au-dessus du collecteur. Il convient de noter ici que l'une des fonctions de la couche de silicium amorphe 17 est une fonction de protection du reste de la plaquette lors de cette désoxydation chimique et notamment des zones d'isolement latéral lorsque celles-ci sont réalisées par des tranchées peu profondes.

On procède ensuite, après un traitement de désorption de la fenêtre de base sous hydrogène à une température supérieure à 600°C, à une épitaxie d'un empilement 8 de trois couches 80, 81 et 82, au sein desquelles sera réalisée la future base du transistor. Plus précisément, on procède à une épitaxie d'une première couche 80 de silicium non dopée sur une épaisseur de quelques dizaines de nanomètres. La deuxième couche 81 formée de silicium-germanium est ensuite épitaxiée. Elle est en fait composée d'une première sous-couche de Si₁₋ₓGeₓ avec x constant compris entre 0,1 et 0,2, surmontée d'une deuxième sous-couche formée également d'un alliage de Si₁₋ₓGeₓ (avec x par exemple décroissant jusqu'à 0) et dopée P par du bore. L'épaisseur totale de la couche 81 est peu importante, typiquement de 20 à 100 nm.

La deuxième sous-couche de la couche 81 est ensuite surmontée d'une couche épitaxiée 82 de quelques dizaines de nanomètres d'épaisseur de silicium dopé P à partir de bore.

A l'issue de cette épitaxie, réalisée typiquement à 700°C dans un réacteur de dépôt CVD ultrapropre, on obtient donc un empilement de couches monocristallines sur le collecteur intrinsèque dans la fenêtre de base, et polycristallines au-dessus des couches de silicium amorphe 17. Cet empilement de couches va permettre de former une base à hétérojonction silicium-germanium. Il est à noter ici que l'épitaxie de réalisation de la base à hétérojonction est une épitaxie non sélective.

Par ailleurs, la présence de la couche de silicium amorphe 17 permet de présenter en début d'épitaxie une surface essentiellement formée de silicium ce qui permet d'obtenir une vitesse de croissance sensiblement identique sur le collecteur intrinsèque et sur le silicium amorphe conduisant à l'obtention d'une meilleure homogénéité en épaisseur de la base.

On dépose ensuite sur la couche 81 une première couche de dioxyde de silicium ayant une épaisseur de l'ordre de 200 Å. On dépose également sur la première couche de dioxyde de silicium 9, une deuxième couche 10 de nitrure de silicium (Si₃N₄) ayant une épaisseur de 300 Å.

On définit ensuite (figure 3) à l'aide d'un masque une zone 100 dans la couche de nitrure 10 correspondant à une fenêtre émetteur située au-dessus du collecteur intrinsèque 4. On effectue alors de façon classique, à l'aide d'une couche de résine correspondant audit masque, une gravure plasma de la couche de nitrure 10 avec arrêt sur la couche de dioxyde de silicium 9 de façon à dégager la zone 100. On procède ensuite, en conservant la résine présente sur la couche 10 et ayant servi à la gravure de cette dernière, à l'implantation de phosphore, à travers la base. Un surdopage sélectif du collecteur ("selective implantation collector") sous la fenêtre de l'émetteur peut être réalisé en une ou plusieurs implantations contribuant ainsi à augmenter la rapidité du transistor en diminuant la résistance du collecteur. On obtient donc sous la fenêtre émetteur une zone SIC surdopée.

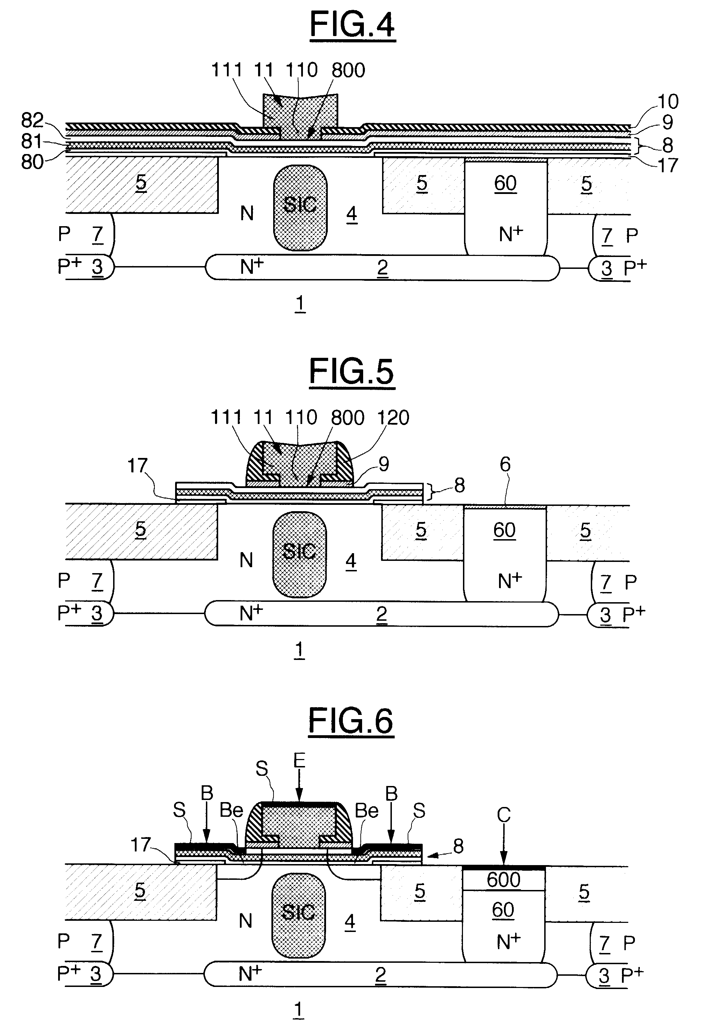

A l'issue de cette étape, on retire la résine présente sur la couche de nitrure de silicium 10 et l'on procède à un traitement chimique de desoxydation de façon à retirer la partie de la couche de dioxyde de silicium 9 située dans la zone 100 et réaliser ainsi la fenêtre émetteur 800 (figure 4).

Un exemple d'un tel traitement chimique de désoxydation consiste à utiliser un bain d'acide à base d'acide fluorhydrique dilué à environ 1% pendant 1 minute, ce qui permet d'obtenir une surface de silicium monocristallin chimiquement propre, c'est-à-dire dont la concentration d'atomes d'oxygène est inférieure à 10¹⁵/cm². Par ailleurs, une telle désoxydation chimique ne dégrade pas la surface de silicium monocristallin sous-jacente (au contraire d'une gravure plasma par exemple) et par conséquent n'introduit pas de défauts cristallins.

Pour parfaire encore l'état de surface du silicium, on effectue avantageusement un traitement de désorption sous hydrogène à haute température (> à 550°C) de façon à évacuer des impuretés résiduelles adsorbées sur la surface du silicium lors de la désoxydation.

On procède ensuite dans un réacteur de dépôt CVD ultrapropre, par exemple celui commercialisé par la Société Applied Materials sous la référence Centura HTF, à la réalisation de l'émetteur du transistor.

Plus précisément, on expose le bloc semiconducteur avec la base découverte au niveau de la fenêtre émetteur 800 à un mélange gazeux de silane et d'arsine, dans une atmosphère non oxydante, typiquement sous vide, ou sous hydrogène.

Les conditions du dépôt CVD sont par exemple un débit de 10 litres d'hydrogène/mn, un débit de 0,5 litres de silane/mn et un débit de 0,12 cm³ d'arsine/mn, à 630°C et sous une pression de 80 Torr.

L'homme du métier aura remarqué que ces conditions correspondent en fait à un dépôt polysilicium. Cependant, en raison du caractère chimiquement propre de la surface monocristalline de la base découverte au niveau de la fenêtre 800, le silicium déposé dans ce réacteur, épitaxie, c'est-à-dire qu'il croît monocristallin sur la base.

Après avoir obtenu une couche de silicium ayant une épaisseur de l'ordre de 2500 Å, on procède, de façon classique en utilisant un nouveau masque de photolithographie ainsi qu'un bloc correspondant de résine, à une gravure de la couche de silicium de façon à obtenir (figure 4) un émetteur 11 comportant dans la fenêtre 80 une partie inférieure 110 surmontée d'une partie supérieure 111 plus large que la fenêtre émetteur, la distance entre le bord de la fenêtre émetteur et le bord de la région 111 étant typiquement de l'ordre de 0,2 µ. Cet émetteur a donc été dopé in situ et il est monocristallin au moins au voisinage de l'interface avec la base dans la fenêtre émetteur. Il a été observé en pratique qu'il était monocristallin au voisinage de l'interface, polycristallin au-dessus du nitrure, et possédait une orientation préférentielle dans la partie épitaxiée supérieure au-dessus de la fenêtre.

On procède ensuite à un dépôt d'une couche de nitrure de silicium que l'on grave de façon à obtenir des espaceurs 120 incluant la couche 10 de nitrure de silicium, s'appuyant sur les parois verticales de la région supérieure 111 de l'émetteur et sur la couche de dioxyde de silicium 9 (figure 5).

On définit ensuite à l'aide d'un nouveau masque, la géométrie de la base du transistor et l'on procède, après avoir préalablement gravé la couche d'oxyde 9, à une gravure de l'empilement des couches 17 et 8 de façon à obtenir la configuration illustrée sur la figure 5.

On dépose ensuite de part et d'autre de la base un bloc de résine, ainsi qu'une vignette de résine au-dessus de l'émetteur, puis on procède à une implantation P⁺ de l'empilement 8 à l'aide de bore, de façon à définir la base extrinsèque Be (figure 6). On procède ensuite, après avoir protégé le transistor par de la résine, à une implantation d'arsenic, de façon à réaliser à la surface du puits collecteur une zone implantée N⁺ référencée 600.

L'étape finale consiste à réaliser les prises des connexions S de base d'émetteur et de collecteur par une technique connue du type "siliciure autoaligné" ("self aligned silicide") qui comporte le dépôt d'une couche de métal (par exemple du titane) pour former un siliciure (TiSi₂) sur les zones de silicium de la base extrinsèque, de l'émetteur et du collecteur extrinsèque.

Le transistor selon l'invention, tel qu'illustré sur la figure 6, est donc un transistor bipolaire vertical n-p-n à base à hétérojonction silicium-germanium utilisable dans une technologie BiCMOS du type VLSI. Il comporte un émetteur monocristallin directement en contact avec le silicium de la couche supérieure d'encapsulation (82). Cependant, en raison notamment des diffusions de dopants et de divers traitement thermiques classiques, la jonction émetteur/base se situe à l'intérieur de la couche 82. Le transistor présente un bruit basse fréquence réduit, tout en conservant de bons paramètres statiques, notamment le gain en courant. Il présente en outre une résistance d'émetteur réduite par rapport à des transistors à émetteur polycristallin.

Dans la variante de réalisation qui vient d'être décrite, la distance entre le bord de la fenêtre 800 et le bord de la région supérieure de l'émetteur dépend de l'alignement du masque de photolithographie utilisé pour la gravure de la région supérieure de l'émetteur par rapport au masque de photolithographie utilisé pour la gravure de la fenêtre émetteur proprement dite. Ceci rend un peu plus délicate la fabrication du transistor.

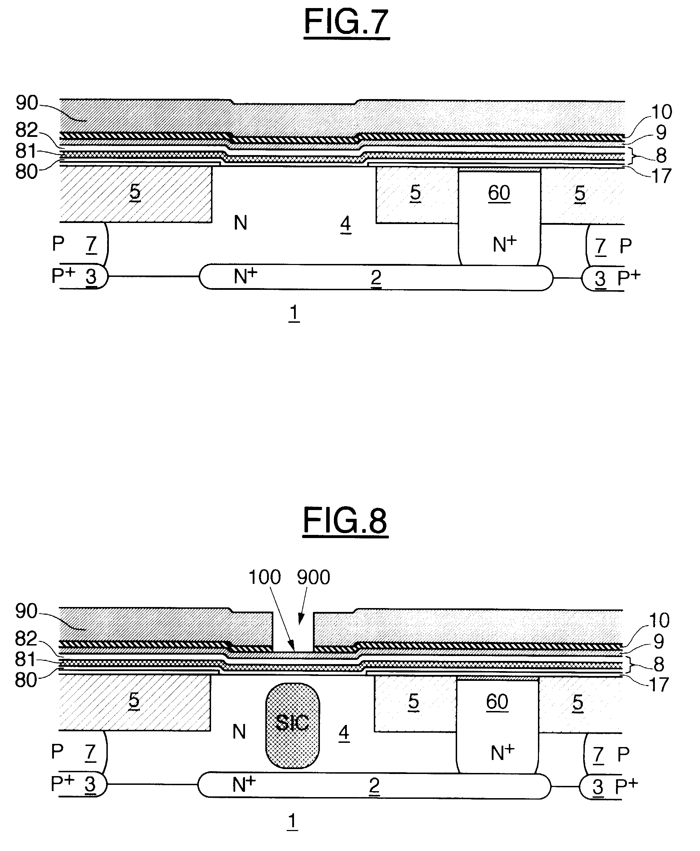

La variante de réalisation illustrée sur les figures 7 à 11 permet de s'affranchir de ce problème. En effet, comme illustré sur la figure 7, on dépose sur la couche 10 de nitrure de silicium une troisième couche épaisse de dioxyde de silicium 90 (ayant typiquement une épaisseur de 2000Å). On procède ensuite (figure 8) à une gravure plasma classique de la couche épaisse 90 avec arrêt sur la deuxième couche 10 de nitrure de silicium, d'une région 900 correspondant à l'emplacement de la zone 100 de la couche 10 (figure 3) et par conséquent à l'emplacement de la fenêtre émetteur 800. On poursuit la gravure de la fenêtre émetteur d'une façon analogue à celle qui a été décrite dans le mode de mise en oeuvre précédent. De même, l'implantation de la zone SIC est analogue à celle qui était décrite ci-avant.

On procède ensuite d'une façon analogue à celle qui a été décrite ci-avant, au dépôt de silicium dans des conditions de dépôt polysilicium provoquant la ré-épitaxie du silicium sur la base dans la cavité ménagée au sein de l'empilement des couches successives de dioxyde de silicium 9, de nitrure de silicium 10 et de dioxyde de silicium 90.

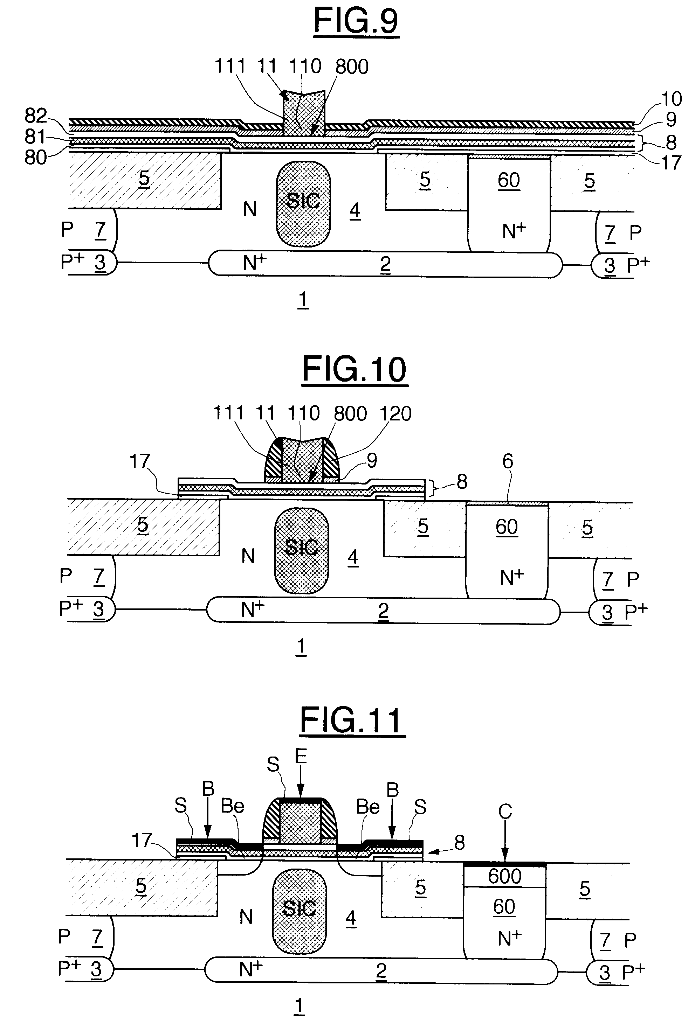

On supprime ensuite, par exemple par un polissage mécanochimique, ou bien par une gravure pleine plaque avec arrêt sur la couche d'oxyde 90, le silicium débordant en dehors de la cavité puis on procède (figure 9) à une gravure plasma de la couche 90 de part et d'autre du silicium monocristallin épitaxié, avec arrêt sur la couche de nitrure de silicium 10, de façon à obtenir un émetteur formé d'un seul bloc 110 ayant la même largeur que la fenêtre émetteur.

Les étapes suivantes de cette mise en oeuvre, et notamment la formation des espaceurs 120, sont analogues à celles qui ont été décrites ci-avant.

On obtient de ce fait une distance réduite entre le bord de l'émetteur et le bord des espaceurs 120, distance qui n'est plus contrôlée par une opération de photolithographie.

Outre la simplification technologique, on obtient une résistance de base plus faible et une capacité base collecteur plus faible pour le transistor illustré sur la figure 11.

Enfin, dans l'une ou l'autre des deux variantes qui viennent d'être décrites, il est particulièrement avantageux lors de la réalisation de l'émetteur dopé in situ de moduler la quantité de gaz dopant au fur et à mesure de l'épitaxie de l'émetteur. Ainsi, au début de l'épitaxie, on gardera par exemple le débit d'arsine mentionné ci-avant (0,12cm³/mn) tandis que dans la région supérieure de l'émetteur, on diminuera ce débit pour atteindre par exemple la valeur de 0,6 cm³/min. On obtiendra donc finalement, pour l'émetteur dopé in situ, une concentration de dopant As égale par exemple à 3 10²⁰/cm³ dans la région inférieure de l'émetteur au contact de la base et une concentration de dopant As égale par exemple à 10²⁰/cm³ dans la région supérieure de l'émetteur. Ces valeurs permettent d'obtenir donc à la fois une bonne injection d'électrons dans la partie inférieure de l'émetteur et une bonne siliciuration au-dessus de la partie supérieure de l'émetteur.

## Revendications

1. Procédé de fabrication d'un transistor bipolaire vertical, caractérisé par le fait qu'il comprend une étape de réalisation d'un collecteur intrinsèque (4) sur une couche de collecteur extrinsèque (2) enterrée dans un substrat semiconducteur (1), une étape de réalisation d'une région d'isolement latéral (5) entourant la partie supérieure du collecteur intrinsèque et d'un puits de collecteur extrinsèque déporté (60), une étape de réalisation d'une base à hétérojonction SiGe (8) située au-dessus du collecteur intrinsèque et de la région d'isolement latéral comportant une épitaxie non sélective d'un empilement (8) de couches comportant au moins une couche de SiGe (81) et une étape de réalisation d'un émetteur dopé in situ (11) comportant une épitaxie sur une fenêtre prédéterminée (800) de la surface dudit empilement situé au-dessus du collecteur intrinsèque de façon à obtenir au moins au-dessus de ladite fenêtre, une région d'émetteur formée de silicium monocristallin et directement en contact avec la couche supérieure (82) dudit empilement (8).

2. Procédé selon la revendication 1, caractérisé par le fait que l'étape de réalisation de l'émetteur comprend
une première phase comportant le dépot sur la surface dudit empilement (8) d'une première couche de dioxyde de silicium (9), le dépôt sur la première couche de dioxyde de silicium (9) d'une deuxième couche de nitrure de silicium (10), une gravure dans la couche de nitrure de silicium (10) avec arrêt sur la première couche de dioxyde de silicium (9) d'une zone (100) correspondant à l'emplacement de ladite fenêtre (80), une désoxydation chimique de ladite zone (100) de façon à obtenir dans ladite fenêtre (80) une surface de silicium ayant une concentration d'atomes d'oxygène inférieure à 10¹⁵ par cm², et
une deuxième phase comportant l'exposition du bloc semiconducteur obtenu à ladite première phase, à un mélange gazeux de silane et de dopants en atmosphère contrôlée non oxydante.

3. Procédé selon la revendication 2, caractérisé par le fait qu'à l'issue de la deuxième phase on obtient une couche de silicium, monocristallin au moins au-dessus de ladite fenêtre, que l'on grave de façon à former un émetteur (11) comportant une région supérieure (111) plus large que la fenêtre (80) et s'appuyant sur une partie de la couche de nitrure de silicium (10), et par le fait qu'on forme des espaceurs isolants (120) au contact des parois verticales de la région supérieure plus large de l'émetteur.

4. Procédé selon la revendication 2, caractérisé par le fait que ladite première phase comporte le dépôt sur la deuxième couche de nitrure de silicium (10) d'une troisième couche épaisse de dioxyde de silicium (90), et une gravure préliminaire dans la troisième couche de dioxyde de silicium (90) avec arrêt sur la deuxième couche de nitrure de silicium (10) d'une région (900) correspondant à l'emplacement de ladite zone (100), de façon à obtenir à l'issue de la première phase un bloc semi-conducteur comportant dans l'empilement des trois couches isolantes une cavité de même largeur que ladite fenêtre (80), par le fait qu'à l'issue de la deuxième phase on obtient un remplissage de ladite cavité par ladite épitaxie, par le fait qu'on grave la troisième couche de dioxyde de silicium (90) de part et d'autre du bloc émetteur (110) formé dans la cavité et on forme des espaceurs isolants au contacts des parois verticales de l'émetteur.

5. Procédé selon l'une des revendications 2 à 4, caractérisé par le fait que dans ladite deuxième phase on module la quantité de gaz dopant de façon à obtenir une concentration de dopants plus faible dans la partie supérieure (111) de l'émetteur que dans la partie inférieure (110) directement en contact avec la base.

6. Transistor bipolaire vertical, caractérisé par le fait qu'il comprend un collecteur intrinsèque (4) disposé sur une couche de collecteur extrinsèque (2) enterrée dans un substrat semiconducteur, une région d'isolement latéral (5) entourant la partie supérieure du collecteur intrinsèque, un puits de collecteur extrinsèque déporté (60), une base à hétérojonction SiGe (8) située au-dessus du collecteur intrinsèque et de la région d'isolement latéral et formée dans un empilement de couches comportant au moins une couche de SiGe (81) et un émetteur dopé (11), entouré par la base, comportant au moins au-dessus d'une fenêtre prédéterminée (800) de la surface dudit empilement située au-dessus du collecteur intrinsèque, une région d'émetteur formée de silicium monocristallin et directement en contact avec la couche supérieure (82) dudit empilement (8).

7. Transistor selon la revendication 6, caractérisé par le fait que ladite fenêtre (800) de la surface dudit empilement (8) comporte une concentration d'atomes d'oxygène inférieure à 10¹⁵ par cm².

8. Transistor selon la revendication 6 ou 7, caractérisé par le fait que l'émetteur comporte une région supérieure (111) plus large que la fenêtre (800) et s'appuyant sur une couche de nitrure de silicium (10) elle-même supportée par une couche de dioxyde de silicium (9) reposant sur une partie de la base, et par le fait qu'il comporte des espaceurs isolants (20) au contact des parois verticales de la région supérieure plus large de l'émetteur et s'appuyant sur la couche de dioxyde de silicium (9).

9. Transistor selon la revendication 6 ou 7, caractérisé par le fait que l'émetteur est formé d'un bloc (110) de même largeur que la fenêtre (800) s'appuyant intégralement directement sur ledit empilement (8), et par le fait qu'il comporte des espaceurs isolants (120) au contacts des parois verticales de l'émetteur et s'appuyant sur une couche de dioxyde de silicium (9).

10. Transistor selon l'une des revendications 6 à 9, caractérisé par le fait que l'émetteur (11) est dopé plus faiblement dans sa partie supérieure que dans sa partie inférieure directement en contact avec ledit empilement.
